Europäisches Patentamt

**European Patent Office**

Office européen des brevets

(19)

(11) Publication number: **0 220 791**
**B1**

## EUROPEAN PATENT SPECIFICATION

(12)

(45) Date of publication of the patent specification:
14.06.89

(51) Int. Cl.⁴: **H 03 K 17/56**, H 03 K 17/08

(21) Application number: **86304600.9**

(22) Date of filing: **16.06.86**

(54) **Switching device.**

(30) Priority: **18.06.85 JP 132661/85**
**18.06.85 JP 132662/85**

(43) Date of publication of application:
**06.05.87 Bulletin 87/19**

(45) Publication of the grant of the patent:
**14.06.89 Bulletin 89/24**

(84) Designated Contracting States:
**DE FR GB**

(56) References cited:
**EP-A- 0 108 283**
**DE-A- 3 338 627**
**GB-A- 2 053 606**
**US-A- 3 829 708**
**US-A- 3 911 296**
**US-A- 4 547 686**

**ELECTRONIQUE APPLICATIONS, no. 31,**
**August/September 1983, pages 35-44, Evry, FR; K.**
**RISCHMULLER "Darlington, Bipmos, Cascode:**
**caractéristiques et critères d'emploi"**

(73) Proprietor: **FUJI ELECTRIC CO., LTD., 1-1,**
**Tanabeshinden, Kawasaki-ku, Kawasaki-shi**
**Kanagawa 210 (JP)**

(72) Inventor: **Shigekane, Hisao, B-406, Yokota 180-10,**
**Matsumoto-shi Nagano 390 (JP)**

(74) Representative: **Gordon, Martin et al, G.F. Redfern &**
**Company Marlborough Lodge 14 Farncombe Road,**
**Worthing West Sussex, BN11 2BT (GB)**

## Description

This invention relates to a switching device comprising two transistors, that is, a first bipolar transistor and a second field effect or bipolar transistor.

In the following description and in the drawings, identical reference numerals are used in relation to identical or corresponding components.

A prior art arrangement and problems associated with it will now be described with reference to Fig. 6 in which is shown one embodiment of a circuit comprising two transistors in a so-called cascode arrangement.

Referring to Fig. 6, a main bipolar transistor Q1 (hereinafter referred to as a BPT), a field effect transistor Q2 (hereinafter referred to as an FET) and a zener diode ZD1 are interconnected as shown.

The collector G1 and the emitter E1 of the BPT Q1, and the drain D and the source S of the FET Q2 are connected in series at the emitter E and the drain D to enable current supplied to a load (not shown) to be switched ON-OFF (for the sake of convenience, this current is referred to herein as the collector current). Further, the transistors Q1 and Q2 are collectively referred to as a composite transistor for the sake of the convenience. The zener diode ZD1 is connected between the base B1 of the BPT Q1 and the source S of the FET Q2 in such a way that the side of the base B1 comprises the cathode side of the diode.

An ON-OFF signal voltage $e_G$, determining the ON-OFF state of the collector current $I_c$, is applied by way of a driving circuit (not shown) between the gate G and the source S of the FET Q2, while a base current $I_{B1}$ is supplied to the base B1 via a base power source EB connected between the base B1 of the BPT Q1 and the source S of the FET Q2 when the latter is turned ON.

The circuit is arranged to provide a composite switching element at high speed and high voltage endurance by the combination of high speed and low voltage endurance characteristics of the FET Q2 and low speed and high endurance bipolar characteristics of the transistor Q1 taking notice of the fact that the switching speed of an FET is generally greater than that of a bipolar transistor.

Referring first to the case of turning the composite transistor Q1 and Q2 ON, since the FET Q2 is connected to the emitter E1 of the BPT Q1 to enable the base current $I_{B1}$ to be turned ON and OFF in this circuit, and the base voltage $e_B$ applied to the base B1 of the BPT Q1 can be made relatively high, when the ON-OFF signal voltage $e_G$ is applied to the FET Q2 to turn the transistor Q2 ON, the voltage VDS between the drain D and the source S falls rapidly thereby abruptly raising the base current $I_{B1}$ to rapidly turn BPT Q1 ON and, accordingly, both transistors Q1, Q2 are switched ON. In this case, the zener diode ZD1 is in the OFF state (non-conduction).

When turning OFF the composite transistor Q1 and Q2, an ON-OFF signal voltage $e_G$ is applied to the FET Q2 to turn OFF the transistor Q2. The voltage VDS between the drain D and the source S of the FET Q2 abruptly increases to block the collector current $I_c$. At this instant, the collector current $I_c$ flowing through the base and the emitter of the BPT Q1 is transferred to the zener diode ZD1. In this way, since carriers accumulated at the base of the BPT Q1 are rapidly discharged, the transistor Q1 and, accordingly, the composite transistor Q1 and Q2, is rapidly turned OFF to interrupt the collector current $I_c$.

In this case, the zener diode ZD1 is used in the transferring path as described above, so as to maintain the voltage VDS between the drain and the source of the FET Q2 lower than a limit voltage capable of turning off (switching inhibition voltage BVDS) upon turning OFF the FET Q2, that is, upon transfer of the collector current $I_c$, while hindering wasteful shunting, via the zener diode, of the base current $I_{B1}$ supplied from the base power supply EB to the connection to the base B1 of the BPT Q1, in the case where the composite transistor Q1 and Q2 is turned ON, so that it effectively forms the base current $I_B$.

The circuit shown in Fig. 6 suffers from the following problems when turning OFF the composite transistor Q1, Q2.

(1) When the FET Q2 is turned OFF and the carriers accumulated at the base of the BPT Q1 are discharged through the zener diode ZD1, since the threshold voltage of the zener diode ZD1 is high, the heat generation is increased in the zener diode ZD1 and it is necessary to use a large capacity and very expensive zener diode ZD1.

(2) Since the fall time as the measure for the interruption time of the collector current $I_c$ is too fast, a spike voltage $L\, dI_c/dt$ caused by the tendency of the stray inductance L of the wiring in the flow path of the current $I_c$ to maintain that current ($dI_c/dt$ relative to the rate of change of the collector current $I_c$) is generated possibly to destroy the transistors Q1 and Q2.

In previously published DE 33 38 627 A1 there is disclosed a switching device comprising a first bipolar transistor having its collector-emitter main conductive path connected in series with the main conductive path of a second transistor having a control electrode for receiving an ON-OFF control signal voltage for switching ON and OFF the second transistor so as to open and close the series-connected main conductive paths for controlling the supply of a load current, connections being provided for connection to an auxiliary D.C. power source for supplying base current to the first transistor, a third transistor having its main conductive path connected across said base current supply connections. This prior arrangement has the disadvantage that it is necessary to supply an external signal to control the third transistor.

It is an object of the invention to provide a semiconductor device capable of repeatedly turning ON and OFF electrical current supplied to an external load using a composite transistor, wherein at least one of the foregoing problems is ameliorated, heat generation can be reduced during operation so that smaller capacity and less expensive components can be used, and destruction of the composite transistor can be avoided without losing the high speed switching function of the transistor arrangement.

According to this invention there is provided a switching device comprising a first bipolar transistor having its collector-emitter main conductive path connected in series with the main conductive path of a second transistor having a control electrode for receiving an ON-OFF control signal voltage for switching ON and OFF the second transistor so as to open and close the series-connected main conductive paths for controlling the supply of a load current, connections being provided for connection to an auxiliary D.C. power source for supplying base current to the first transistor, a third transistor having its main conductive path connected across said base current supply connections characterised in that a capacitor is connected between the base of the first transistor and the control electrode of the third transistor such that when said second transistor is switched OFF a change in voltage across said base current supply causes current to flow through said capacitor to switch ON the third transistor whereby the main conductive path of the latter acts as a controlled shunt path across said base current supply connections.

Embodiments of this invention will now be described, by way of example, with reference to the accompanying drawings in which:—

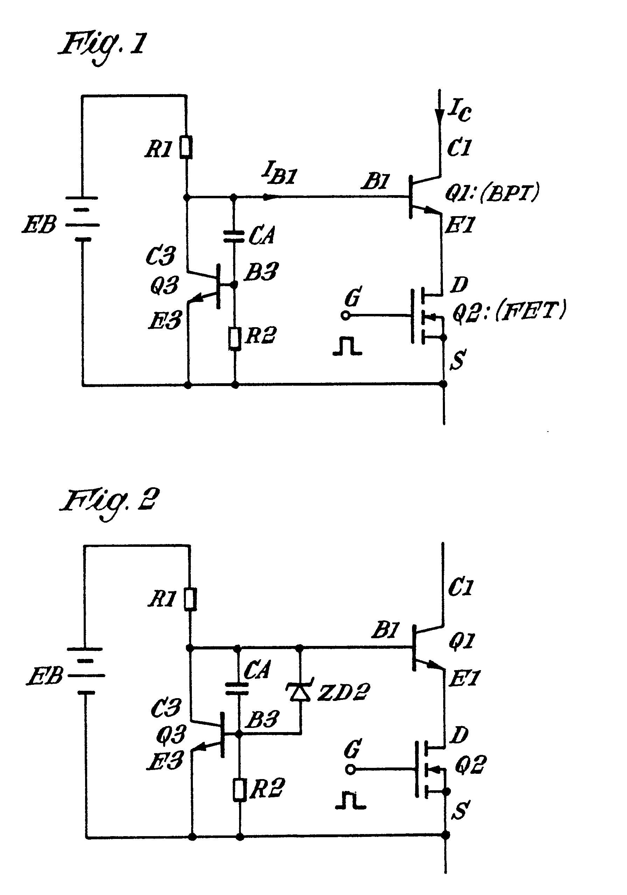

Figs. 1 to 5 are respective circuit diagrams of different forms of semiconductor switching devices embodying this invention.

In Fig. 1 there is shown a semiconductor switching device in which an auxiliary transistor Q3 is connected, in place of the zener diode ZD1 in a modified form of the circuit shown in Fig. 6, so as to be capable of shunting the base current $I_{B1}$ of the BPT Q1. Further, a capacitor CA is connected between the collector C3 and the base B3 of the transistor Q3 and a base resistor R2 is connected between the base B3 and the emitter E3 of the auxiliary transistor Q3.

Since no base current normally flows to the base B3 of the auxiliary transistor Q3, the transistor Q3 is held OFF. However, when the voltage across the capacitor CA increases, that is the voltage between the base B3 and the collector C3 and, accordingly, between the emitter E3 and the collector C3 of the transistor Q3, base current flows through capacitor CA to render the auxiliary transistor Q3 conductive. However, since current flowing into the capacitor CA is then shunted and flows through the collector-emitter path of the transistor Q3, the voltage between the collector C3 and the emitter E3 of the auxiliary transistor Q3 rises at a controlled rate (relatively slowly) determined by circuit conditions such as the value for the capacitor CA.

This controlled voltage increase corresponds to switching OFF the composite transistor Q1 and Q2, in which the voltage between the drain D and the source S and, thus, between the base B1 and the source S of the FET Q2 increases due to the turn-OFF of the latter and the carriers accumulated at the base of the BPT Q1 are discharged via the circuit through the auxiliary transistor Q3 as described above. As a result, the voltage between the base B1 and the source S of the composite transistor Q1 and Q2 changes only somewhat slowly and, accordingly, the collector current $I_c$ is also interrupted somewhat slowly. In this way, the magnitude of the associated spike voltage is decreased to avoid destruction of the BPT Q1 and FET Q2.

Further, during the switch OFF operation, the voltage between the collector C3 and the emitter E3 of the auxiliary transistor Q3 rises from the value of the voltage between the base B1 and the source S in the state where the composite transistor Q1 and Q2 is switched ON (lower than the threshold voltage for the zener diode ZD1 in the circuit shown in Fig. 6). Meanwhile, carriers accumulated at the base B1 of the BPT Q1 flow relatively slowly through the collector circuit of the auxiliary transistor Q3 to decrease the heat generation loss of the auxiliary transistor Q3 as compared with that of the zener diode ZD1, which means that a transistor Q3 of smaller capacity and so less cost than the zener diode can be used.

In Fig. 2 there is shown a modified form of the device shown in Fig. 1 in which zener diode ZD2 is connected in parallel with the capacitor CA, in which the upper limit value for the voltage between the collector C3 and the emitter E3 of the auxiliary transistor Q3, that is, the voltage between the base B1 and the source S of the composite transistor Q1 and Q2, can be restricted approximately to the threshold voltage of the zener diode ZD2 in a similar manner to the operation of the zener diode ZD1 shown in Fig. 6. Otherwise the device shown in Fig. 2 operates in the same way as the device shown in Fig. 1.

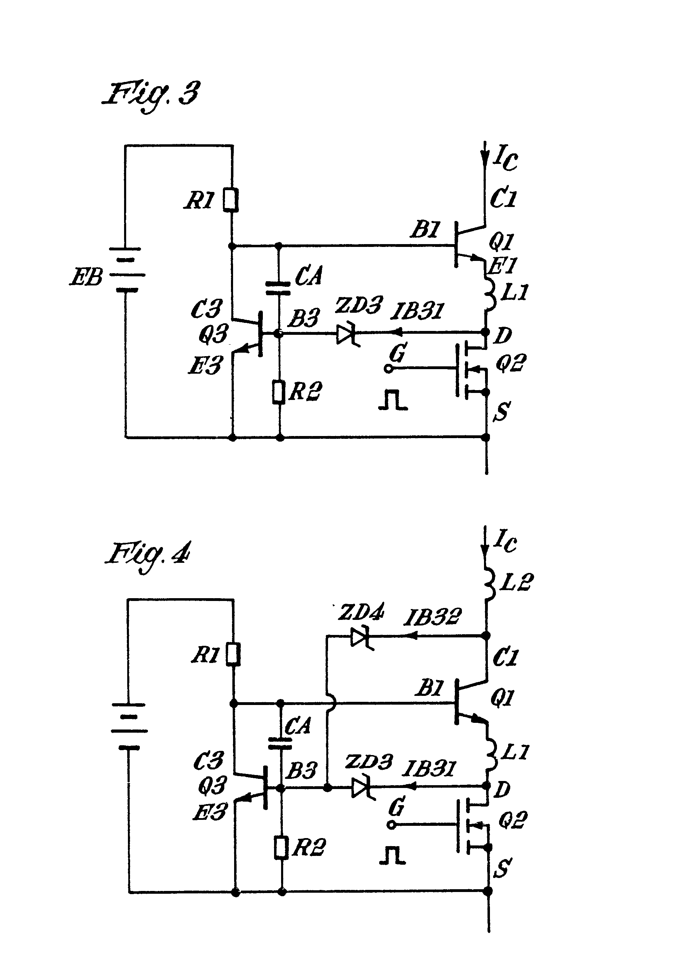

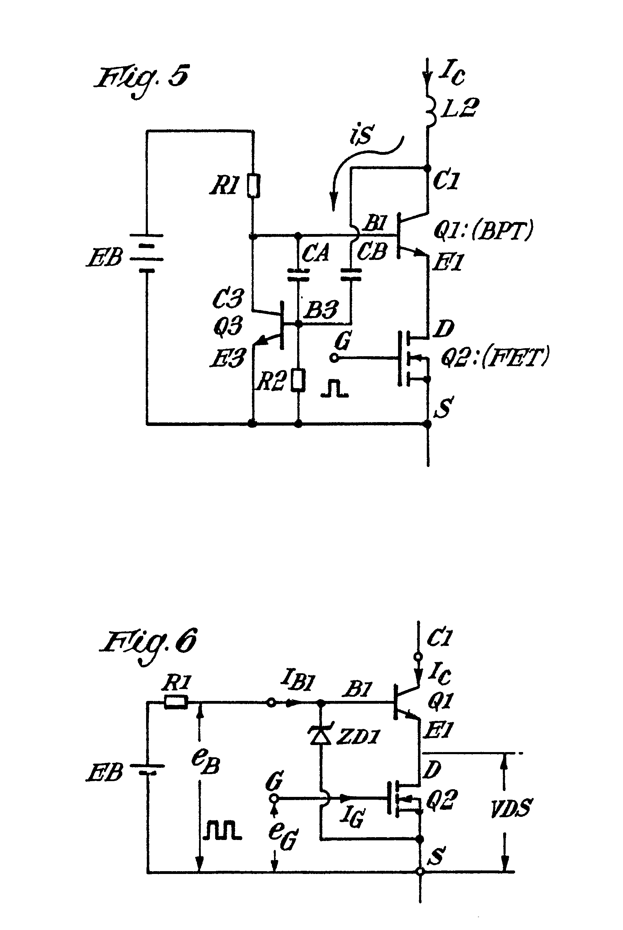

In Figs. 3 and 4 there are shown modified forms of the device shown in Fig. 1 and capable of surely restricting the magnitude of the spike voltage induced by stray inductances L1 and L2 in the flow path of the collector current $I_c$, thereby enhancing the protection from destruction of the transistor Q1 or Q2. In Figs. 3 and 4, L1 represents stray inductance of the wiring between the emitter E1 of the BPT Q1 and the drain D of the FET Q2, while L2 in Fig. 4 represents stray inductance of external main circuit wirings.

Zener diodes ZD3 and ZD4 have threshold voltages respectively selected to take such values as do not exceed the switching inhibition voltage BVDS of the FET Q2 for diode ZD3, and do not exceed the maximum allowable voltage between the collector C1 and the source S of the transistors Q1 and Q2 for diode ZD4.

In this case, when the spike voltage induced by the stray inductance L1 exceeds the threshold voltage for the zener diode ZD3, the spike voltage causes base current IB31 to flow to the auxiliary transistor Q3 by way of the zener diode ZD3, by which the rising voltage between the base B1 and the source S of the composite transistor Q1 and Q2 is moderated in the same manner as described above for the device shown in Fig. 1 (accordingly, the interruption time for the collector current $I_c$ is also moderated and the spike voltage due to the stray inductance is decreased), while the voltage between the drain D and the source S of the FET Q2 is restricted approximately to the threshold voltage for the zener diode ZD3 securely to avoid the destruction of the FET Q2.

In the same manner, in the device shown in Fig. 4, if the spike voltage induced by the stray inductance L2 exceeds the threshold voltage VZ4 for the zener diode ZD4, the spike voltage causes the base current IB32 to flow to the auxiliary transistor Q3 by way of the zener diode ZD4, so that the circuit operates to decrease the spike voltage as described above and the voltage between the collector C1 and the source S of the composite transistor Q1 and Q2 is restricted approximately to the threshold voltage for the zener diode ZD4, thereby avoiding destruction of the BPT Q1.

In Fig. 5 there is shown a further modified form of the device shown in Fig. 1 and of securely restricting the magnitude of the spike voltage induced by the stray inductance L2 in the flow path of the collector current $I_c$ thereby avoiding destruction of the transistor Q1 and/or Q2. In Fig. 5, a capacitor CB is disposed between the collector C1 of the BPT Q1 and the base B3 of the auxiliary transistor Q3.

Specifically, upon switching ON the composite transistor Q1 and Q2, the shunt current iS due to the voltage induced by the stray inductance L2 flows as base current of the auxiliary transistor Q3 by way of the capacitor CB to turn ON the auxiliary transistor Q3 thereby shunting the base current flowing from the base power source EB to the BPT Q1, while causing carriers accumulated at the base of the BPT Q1 to discharge thereby tending to promote the switching OFF of the BPT Q1 in a controlled manner.

Meanwhile, since the impedance between the collector C1 and the source S of the composite transistor is reduced because of the shunt circuit formed via the capacitor C2 and the base emitter path B3E3 of the auxiliary transistor Q3, the voltage rise between the collector C1 and the emitter E1 of the BPT Q1 is suppressed to prevent the BPT Q1 from destruction.

Further, during this switch OFF operation, since the voltage between the collector C3 and the emitter E3 of the auxiliary transistor Q3 ca be made lower than the threshold voltage for the zener diode ZD1 shown in Fig. 6, the heat generation in the auxiliary transistor Q3 can be reduced in comparison with that in the zener diode ZD1.

This invention can similarly be applied where a low voltage bipolar transistor is used instead of the FET Q2, or a field effect transistor is used instead of the bipolar auxiliary transistor Q3 in each of the embodiments shown in Figs. 1 to 5. However, in the case where a field effect transistor is used as the auxiliary transistor Q3, most of the base current of the transistor Q3 is shunted via the base resistor R2. The resistor R2 also constitutes a discharging circuit for the capacitor.

In the semiconductor devices shown in Fig. 5 in which the emitter of a first bipolar transistor is connected with the drain (or collector) of a second field effect (or bipolar) transistor to constitute a composite transistor in a cascode arrangement, by connecting the collector-emitter (or drain-source) path of a third bipolar (or field effect) transistor between the base of the first transistor and the source (or emitter) of the second transistor so as to be capable of shunting the base current for the first transistor, and by correcting a capacitor between the base (or gate) of the third transistor and the base of the first transistor then the third transistor is temporarily switched ON upon switching OFF the composite transistor and the voltage between the collector and emitter (or drain and source) rises from a small value at a controlled rate determined by the values of the components such as the capacitor and the interruption time for the collector current of the composite transistor is also moderated. In this way, the loss generated in the third transistor due to the discharge of carriers accumulated at the base of the first transistor can be reduced thereby enabling the use of a transistor of moderate capacity and cost smaller than for a circuit using a zener diode as in the device shown in Fig. 6.

In addition, the magnitude of the spike voltage induced by the stray inductance in the flow path of the collector current of the composite transistor is also restricted thereby avoiding destruction of the composite transistor.

Thus the embodiments described above provide a switching device comprising a first bipolar transistor Q1 having its collector-emitter main conductive path C1E1 connected in series with the main conductive path DS of a second transistor Q2 having a control electrode G for receiving an ON-OFF control signal voltage $e_G$ for switching ON and OFF the second transistor Q2 so as to open and close the series-connected main conductive paths C1E1, DS for controlling the supply of a load current $I_c$, connections being provided for supplying base current $I_{B1}$ to the first transistor Q1, a third transistor Q3 having its main conductive path C3E3 connected across said base current supply connections and a capacitor CA being connected between the base B1 of the first transistor and the control electrode B3 of the third transistor such that when said second transistor Q2 is switched OFF a change in voltage across said base current supply connections causes current to flow through said capacitor CA to switch ON the third transistor Q3 whereby the main conductive path C3E3 of the latter acts as a controlled shunt path across said base current supply connections.

## Claims

1. A switching device comprising a first bipolar transistor (Q1) having its collector-emitter (C1-E1) main conductive path connected in series with the main conductive path (D-S) of a second transistor (Q2) having a control electrode (G) for receiving an ON-OFF control signal voltage for switching ON and OFF the second transistor so as to open and close the series-connected main conductive paths for controlling the supply of a load current, connections being provided for connection to an auxiliary D.C. power source (EB) for supplying base current ($I_{B1}$) to the first transistor, a third transistor (Q3) having its main conductive path (C3-E3) connected across said base current supply connections characterised in that a capacitor (CA) is connected between the base (B1) of the first transistor and the control electrode (B3) of the third transistor such that when said second transistor is switched OFF a change in voltage across said base current supply connections causes current to flow through said capacitor to switch ON the third transistor whereby the main conductive path of the latter acts as a controlled shunt path across said base current supply connections.

2. A switching device according to claim 1, wherein said second and/or third transistor is a field effect transistor whose drain-source path provides said main conductive path.

3. A switching device according to claim 1, wherein said second (Q2) and/or third (Q3) transistor is a bipolar transistor whose collector-emitter path provides said main conductive path.

4. A switching device according to claim 1, wherein said second transistor (Q2) is a field effect transistor and said third transistor (Q3) is a bipolar transistor.

5. A switching device according to any one of the preceding claims wherein a base-control electrode zener diode (ZD2) is connected between, so as to limit the voltage between, the base of the first transistor and the control electrode of the third transistor.

6. A switching device according to any one of the preceding claims, wherein a tap control electrode zener diode (ZD3) is connected between the control electrode of the third transistor and the junction between the main conductive paths of the first and second transistors.

7. A switching device according to any one of the preceding claims wherein a collector-control electrode zener diode (ZD4) or further capacitor (CB) is connected between the control electrode of the third transistor and the collector of the first transistor.

## Patentansprüche

1. Schalteinrichtung bestehend aus einem ersten bipolaren Transistor (Q1), dessen Kollektor-Emitter (C1-E1)-Hauptleitungsbahn mit der Hauptleitungsbahn (D-S) eines zweiten Transistors (Q2) in Serie geschaltet liegt, der eine Steuerelektrode (G) zur Aufnahme einer Ein/Aus-Steuersignalspannung zum EIN- und AUS-Schalten eines zweiten Transistors besitzt, um die in Serie geschalteten Hauptleitungsbahnen zur Steuerung der Versorgung mit einem Arbeits- oder Ladestrom zu öffnen oder zu schließen, wobei Verbindungsleitungen zum Anschließen einer Hilfsgleichstromquelle (EB) vorgesehen sind, um Basisstrom ($I_{B1}$) an den ersten Transistor zu liefern, und bestehend aus einem dritten Transistor (Q3), dessen Hauptleitbahn (C3-E3) über die Basisstromversorgungsleitungen geschaltet ist, dadurch gekennzeichnet, daß ein Kondensator (CA) zwischen die Basis (B1) des ersten Transistors und die Steuerelektrode (B3) des dritten Transistors geschaltet liegt, so daß, wenn der zweite Transistor AUS-geschaltet wird, eine Spannungsänderung über die Basisstromversorgungsleitungen einen Strom durch den Kondensator fließen läßt, um den dritten Transistor EINzuschalten, wodurch die Hauptleitungsbahn des letzteren als eine gesteuerte Shuntbahn über die Basisstromversorgungsleitungen wirksam wird.

2. Schalteinrichtung nach Anspruch 1, dadurch gekennzeichnet, daß als zweiter und/oder dritter Transistor ein Feld(effekt)transistor verwendet wird, dessen Drain-Source-Bahn die Hauptleitungsbahn darstellt.

3. Schalteinrichtung nach Anspruch 1, dadurch gekennzeichnet, daß als zweiter und/oder dritter Transistor (Q2 bzw. Q3) ein bipolarer Transistor verwendet wird, dessen Kollektor-Emitterbahn die Hauptleitungsbahn darstellt.

4. Schalteinrichtung nach Anspruch 1, dadurch gekennzeichnet, daß der zweite Transistor (Q2) ein Feld(effekt)transistor und der dritte Transistor (Q3) ein bipolarer Transistor ist.

5. Schalteinrichtung nach einem der vorhergehenden Ansprüche 1 bis 4, dadurch gekennzeichnet, daß zur Begrenzung der zwischenliegenden Spannung zwischen der Basis des ersten Transistors und der Steuerelektrode des dritten Transistors eine basisgesteuerte Elektrodenzenerdiode (ZD2) geschaltet ist.

6. Schalteinrichtung nach einem der vorhergehenden Ansprüche 1 bis 5, dadurch gekennzeichnet, daß zwischen die Steuerelektrode des dritten Transistors und der Verbindungsstelle zwischen den Hauptleitungsbahnen des ersten und zweiten Transistors eine anzapfgesteuerte Elektrodenzenerdiode (ZD3) geschaltet ist.

7. Schalteinrichtung nach einem der vorhergehenden Ansprüche 1 bis 6, dadurch gekennzeichnet, daß zwischen der Steuerelektrode des dritten Transistors und dem Kollektor des ersten Transistors eine kollektorgesteuerte Elektrodenzenerdiode (ZD4) oder ein weiterer Kondensator (CB) geschaltet ist.

## Revendications

1. Dispositif de commutation comprenant un premier transistor bipolaire (Q1) ayant son trajet principal conducteur collecteur-émetteur (C1-E1) connecté en série avec le trajet principal conducteur (D-S) d'un deuxième transistor (Q2) comportant une électrode de commande (G) servant à recevoir une tension de signal de commande par tout ou rien servant à commuter le deuxième transistor en tout ou rien de manière à fermer et à ouvrir les trajets principaux conducteurs connectés en série pour commander l'alimentation d'un courant de charge, des connexions étant prévues pour la connexion à une source de courant continu auxiliaire (EB) servant à fournir un courant de base (IB1) au premier transistor, un troisième transistor (Q3) ayant son trajet conducteur principal (C3-E3) connecté aux bornes desdites connexions d'alimentation en courant de base, caractérisé en ce qu'un condensateur (CA) est connecté entre la base (B1) du premier transistor et l'électrode de commande (B3) du troisième transistor de telle façon que lorsque ledit deuxième transistor est bloqué, une modification de tension aux bornes desdites connexions d'alimentation en courant de base amène le courant à circuler à travers ledit condensateur pour rendre conducteur le troisième transistor grâce à quoi le trajet conducteur principal de ce dernier agit comme un trajet dérivé commandé aux bornes desdites connexions d'alimentation en courant de base.

2. Dispositif de commutation selon la revendication 1, dans lequel ledit deuxième et/ou troisième transistor est un transistor à effet de champ dont le trajet drain/source fournit ledit trajet conducteur principal.

3. Dispositif de commutation selon la revendication 1, dans lequel ledit deuxième (Q2) et/ou troisième (Q3) transistor est un transistor bipolaire dont le trajet collecteur-émetteur fournit ledit trajet conducteur principal.

4. Dispositif de commutation selon la revendication 1, dans lequel ledit deuxième transistor (Q2) est un transistor à effet de champ et ledit troisième transistor (Q3) est un transistor bipolaire.

5. Dispositif de commutation selon l'une quelconque des revendications précédentes dans lequel une diode zener à électrode à commande par base (ZD2) est connectée entre la base d'un premier transistor et l'électrode de commande du troisième transistor, de manière à limiter la tension entre celles-ci.

6. Dispositif de commutation selon l'une quelconque des revendications précédentes, dans laquelle une diode zener à électrode à commande par prise (ZD3) est connectée entre l'électrode de commande du troisième transistor et la jonction entre les trajets conducteurs principaux des premier et deuxième transistors.

7. Dispositif de commutation selon l'une quelconque des revendications précédentes dans lequel une diode zener à électrode à commande par collecteur (ZD4), ou un condensateur supplémentaire (CB), est connecté entre l'électrode de commande du troisième transistor et le collecteur du premier transistor.

*Fig. 1*

*Fig. 2*

7

*Fig. 3*

*Fig. 4*

Fig. 5

Fig. 6